(19) Europäisches Patentamt / European Patent Office / Office européen des brevets

(11) **EP 2 618 368 A1**

(12) **DEMANDE DE BREVET EUROPEEN**

(43) Date de publication:
24.07.2013 Bulletin 2013/30

(51) Int Cl.:
*H01L 21/60* (2006.01)    *H01L 23/485* (2006.01)

(21) Numéro de dépôt: 13163706.8

(22) Date de dépôt: 19.02.2009

(84) Etats contractants désignés:
AT BE BG CH CY CZ DE DK EE ES FI FR GB GR HR HU IE IS IT LI LT LU LV MC MK MT NL NO PL PT RO SE SI SK TR

(30) Priorité: 22.02.2008 FR 0851142

(62) Numéro(s) de document de la (des) demande(s) initiale(s) en application de l'article 76 CBE:
09723285.4 / 2 255 383

(71) Demandeur: Commissariat à l'Énergie Atomique et aux Énergies Alternatives
75015 Paris (FR)

(72) Inventeurs:
• Marion, François
38950 Saint Martin Le Vinoux (FR)
• Saint-Patrice, Damien
26120 Chabeuil (FR)

(74) Mandataire: Cabinet Laurent & Charras
Le Contemporain
50 Chemin de la Bruyère
69574 Dardilly Cedex France (FR)

Remarques:
Cette demande a été déposée le 15-04-2013 comme demande divisionnaire de la demande mentionnée sous le code INID 62.

(54) **Composant de connexion muni d'inserts creux et son procédé de réalisation**

(57) La présente invention concerne un procédé de réalisation d'un composant de connexion (2) muni sur une surface de connexion d'inserts (1) conducteurs destinés à être insérés dans des plots conducteurs respectifs ménagés sur une face d'un autre composant de connexion pour une hybridation du type face contre face, chaque insert (1) comprenant :

■ une âme métallique creuse constituée d'un fond disposé sur la surface de connexion du composant et d'une paroi latérale faisant saillie dudit fond, définissant une surface interne de l'insert; et

■ une couche métallique mouillable recouvrant uniquement la surface interne de l'âme métallique.

Figure 2

EP 2 618 368 A1

**Description**

**DOMAINE DE L'INVENTION**

Le domaine technique auquel se rapporte l'invention est celui de la microélectronique, et plus spécifiquement celui de la fabrication, sur tranches de composants semi-conducteurs, de motifs métalliques de forme creuse, avantageusement biseautés, facilitant par exemple la connexion verticale (mieux connue sous l'expression anglo-saxonne « *flip-chip* ») de deux composants.

La présente invention peut être appliquée à toutes sortes de dispositifs requérant des interconnexions de motifs métalliques à très petit pas, notamment pour la fabrication d'imageurs de très grande dimension à très petits pas.

**ETAT ANTERIEUR DE LA TECHNIQUE**

Actuellement, on connaît principalement deux possibilités pour assembler, selon la technique «flip chip par thermocompression», deux composantes nécessitant un grand nombre de liaisons électriques verticales à très petit pas :

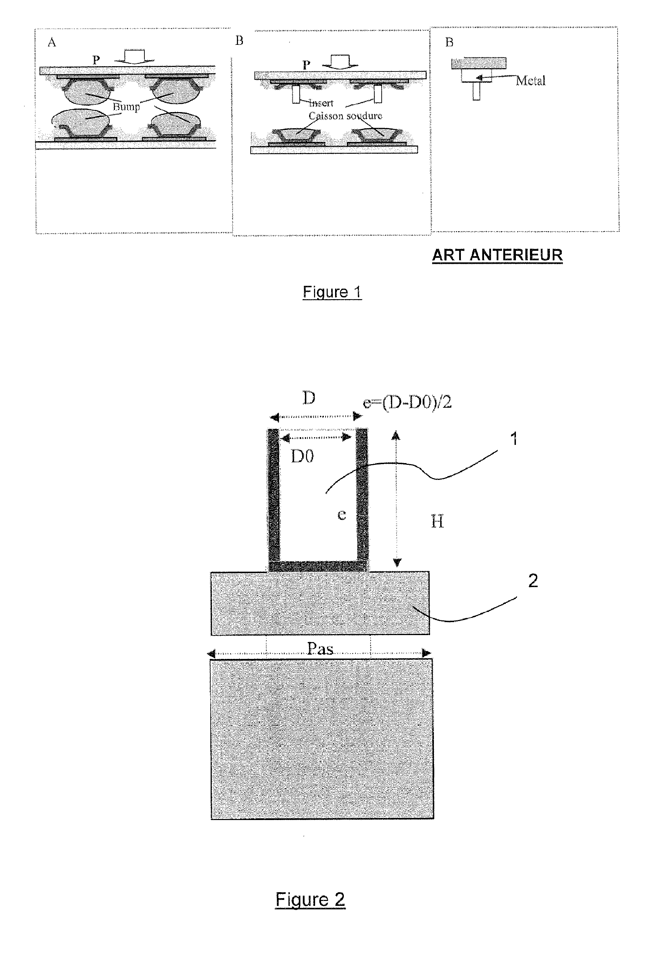

- la première technique de thermocompression consiste à presser, en température, deux billes l'une sur l'autre de manière à les lier par déformation plastique (Fig. 1A).

- la seconde technique, développée pour les pas d'interconnexion les plus fins, permet de travailler à une température plus basse que les températures mises en oeuvre dans la première technique : il s'agit de remplacer l'une des billes thermocompressées par une protubérance « dure » qui casse l'oxyde natif de la soudure à basse température en réduisant la section d'appui (Figure 1B), et permettant ainsi :

    • de réduire la température d'assemblage et la pression d'assemblage ;
    • de contrôler l'écrasement.

Cette seconde technique a fait l'objet de la demande de brevet WO2006/054005 et des inserts adaptés sont décrits dans le document US 6,179,198 (Fig. 1B).

La présente invention s'inscrit dans le cadre de cette deuxième technique, appelée thermocompression par insertion, et tend à résoudre les limitations qui y sont liées, essentiellement au nombre de deux.

Le premier problème est lié aux forces de thermocompression.

En effet, la section de l'insert dans le plan (X, Y) est souhaitée la plus faible possible de manière à limiter la force d'insertion.

Si le nombre de colonnes à insérer augmente, la force d'insertion à exercer sur la pièce à assembler est proportionnelle au nombre $\underline{N}$ de connexions à réaliser, ainsi qu'à la surface de leur section $\underline{S}$, selon la formule suivante :

$$F_{hyb} = k*S*N$$

De ce fait, cette technique est limitée pour les composants à très grand nombre de connexions, sachant par exemple qu'une force de 4 tonnes devrait être envisagée pour l'hybridation d'une matrice de 4 millions de pixels (1 g/bump).

Le problème lié à ces forces peut être exacerbé en raison de la sensibilité des composants assemblés.

Ainsi, certains matériaux à assembler sont très sensibles aux contraintes locales, ce qui entraîne la création de dislocations destructrices lors de l'hybridation par thermocompression.

Alternativement, les forces mises en jeu ne sont plus compatibles avec les précisions d'assemblage requises. En effet, le déplacement maximal latéral requis après hybridation doit être inférieur à 1 micromètre.

Le deuxième problème technique important soulevé par la technique de thermocompression par insertion est lié au mode de réalisation des inserts.

En effet, la réalisation de protubérances dans une fonderie semiconducteur peut devenir un problème pour des pas très réduits. Si l'on réduit la section des inserts, les techniques classiques de réalisation peuvent s'avérer difficiles à mettre en oeuvre, de par la finesse des inserts souhaités.

Cette limitation est donc liée à la notion de finesse minimale de photolithogravure. Ainsi, il n'est pas possible de réduire la section d'un insert classique plein, pour une résolution photolithographique technologique donnée $\underline{D}$, en deçà de la valeur $\pi*D^2/4$.

**EXPOSE DE L'INVENTION**

Ayant analysé l'ensemble de ces contraintes spécifiques, le Demandeur propose une solution technique particulière qui consiste à réduire la section d'insertion dans les caissons de soudure, sans toutefois réduire la surface de contact insert/soudure.

En pratique, il s'agit donc d'obtenir un composant, avantageusement une puce, comportant un ensemble d'inserts conducteurs destinés à être connectés électriquement avec un autre composant, lesdits inserts étant creux.

Le fait de remplacer les inserts pleins, décrits dans l'art antérieur, par des inserts creux selon l'invention permet en effet de réduire la section d'insertion.

Selon un premier aspect, la présente invention concerne donc un procédé de réalisation d'un composant de connexion comportant des inserts conducteurs creux destinés à être connectés électriquement avec un autre composant. De manière caractéristique, ce procédé comprend les étapes suivantes :

- dépôt d'une couche de résine à la surface du composant ;
- réalisation, dans la couche, d'ouvertures adaptées à la forme des inserts ;
- dépôt du ou des matériaux constitutifs des inserts suivant la surface de la couche ;
- élimination du ou des matériaux sur le plan supérieur de la couche ;
- retrait de la couche.

La première étape est donc le dépôt d'une couche dite martyr, avantageusement en résine, qui a pour rôle transitoire de servir de matrice pour la formation des inserts et qui est retirée à l'issue du procédé, avantageusement par délaquage.

De manière avantageuse et dans une seconde étape, les ouvertures réalisées dans la couche le sont par photolithographie.

Selon un mode de réalisation privilégié, le dépôt du ou des matériaux constitutifs des inserts suivant la surface de la couche est réalisé à l'aide de techniques de dépôt de couche mince, alors que leur élimination ultérieure, sur le plan supérieur de la couche, est réalisée par gravure.

Une solution avantageuse, proposée dans le cadre de la présente invention, est de réaliser un insert creux dont la partie supérieure ou extrémité libre est taillée en biais, formant ainsi un biseau. En d'autres termes, la hauteur H varie aux différents points de la circonférence de l'insert. En pratique et au niveau du procédé faisant l'objet de la présente demande, le composant est incliné selon une orientation définie, soit lors du dépôt du ou des matériaux constitutifs des inserts, soit lors de leur élimination.

De manière privilégiée et dans une étape ultérieure, les surfaces interne et externe de l'insert sont recouvertes d'une couche de métal protégeant de l'oxydation, avantageusement de l'or.

A l'issue d'un tel procédé de fabrication relativement simple de mise en oeuvre, on obtient donc un composant de connexion doté d'inserts conducteurs creux, susceptibles d'être connectés à un second composant. En raison de ce procédé, lesdits inserts présentent la particularité d'être fermés à leur base à l'aide d'un socle reposant à la surface du composant, ledit socle présentant la même composition que le corps de l'insert.

De manière avantageuse, les inserts creux selon l'invention présentent une section annulaire (notamment ronde ou ovale) ou parallélépipédique (en particulier carré ou rectangle).

Avantageusement, cette section présente une épaisseur $\underline{e}$, dite épaisseur de peau.

Cette nouvelle forme d'inserts permet de fabriquer ces peaux en mettant en oeuvre des techniques de dépôt de couche mince dérivées des techniques utilisées dans le domaine de la microélectronique et non plus, comme dans l'art antérieur, la technique de la photolithographie, dont les inconvénients ont été mentionnés ci-dessus.

Pour illustrer plus avant ce propos, la photolithographie définit une ouverture limitée d'une résine qui va définir la section du futur insert. Ainsi et à titre d'exemple, si $\underline{D}$ est la limite de résolution de la technologie de photolithogravure, on peut :

- définir un trou qu'on peut remplir par le matériau de l'insert par croissance électrolytique ou par dépôt « *lift off* », l'insert résultant ayant un diamètre égal au diamètre minimum du trou ouvert (minimum D) ;
- déposer une couche du matériau de l'insert et la graver, cette technique étant également limitée par la limite de résolution minimale D.

Il apparaît clairement que la section « efficace » d'un insert suivant l'art antérieur est égale à la surface maximum insérée dans le caisson, soit par exemple en cas d'insert en forme de cylindre de diamètre $\underline{D}$ :

$$S = \pi \cdot D^2/4$$

avec D : la limite de résolution photolithographique.

Dans le cadre de l'invention, pour une section d'insert équivalente, à savoir un diamètre externe $\underline{D}$, et pour la même résolution photolithographique, la surface d'insertion est définie par la formule suivante :

$$S' = \pi \cdot (D^2 - D0^2)/4 = \pi*2*e*2*D/4$$

soit

$$S' = \pi*e*D$$

dans laquelle e définit l'épaisseur de la peau de l'insert et est très inférieure à D.

Le rapport des surfaces S et S', et donc des forces d'insertion F et F', est au final :

$$F'/F = kS'N/kSN = S'/S$$

soit F'/F = 4*e/D (e<<D)

Par ailleurs et comme déjà précisée, la surface de contact doit être maintenue, voire augmentée.

Or, selon la configuration de l'invention, la surface de contact soudure/insert est *de facto* multipliée par environ deux, puisque aussi bien les surfaces externes qu'internes de l'insert creux sont en contact électrique. En revanche et pour un insert plein, seule la surface externe assure ce contact.

Plus précisément et de manière avantageuse, la protubérance définie dans le cadre de l'invention se présente sous la forme d'un tube ou d'un quadrilatère fermé à la base par un socle reposant sur le composant, avantageusement une puce.

L'insert creux selon l'invention est réalisé à base de métal pour assurer sa fonction de conduction électrique. Il s'agit avantageusement d'un matériau de dureté supérieure à celle du matériau dans lequel il sera inséré. Par exemple, il peut s'agir de cuivre (Cu), de titane (Ti), de tungstène (W), de WSi, de chrome (Cr) ou d'un multicouche de ces matériaux. Dans ce cas et de manière avantageuse, l'une des couches fait office de couche barrière de diffusion du matériau dans lequel il est inséré : par exemple Ni, Pd, Pt, WN, TiN.....

De manière privilégiée et comme déjà dit, les surfaces interne et externe de l'insert sont recouvertes d'une couche de métal protégeant de l'oxydation, avantageusement de l'or.

Selon un mode de réalisation avantageux, un tel insert creux présente, comme caractéristique additionnelle, une extrémité supérieure biseautée.

On entend ici par extrémité supérieure, la partie située à l'opposé de l'extrémité formée par le socle et servant de base d'appui sur le composant. La partie biseautée correspond donc à celle qui est engagée dans l'hybridation avec le second composant, via son insertion dans un plot de connexion.

En effet, il a été constaté, dans le cadre de la présente invention, que l'introduction des protubérances creuses dans les plots pouvait entraîner l'emprisonnement de poches d'air au fond de l'insert.

Une première solution pour remédier à cet inconvénient est de réaliser l'hybridation sous vide.

Une seconde solution avantageuse, proposée dans le cadre de la présente invention, est de réaliser un insert creux dont la partie supérieure ou extrémité libre est taillée en biais, formant ainsi un biseau. En d'autres termes, la hauteur H varie aux différents points de la circonférence de l'insert.

Selon une variante de l'invention, l'insert est inséré dans un autre insert du même type que celui précédemment décrit, et déposé sur l'autre composant avec lequel la connexion est recherchée.

Avec un tel dispositif, un procédé d'hybridation particulier est mis en oeuvre :

- dans une étape de pré-insertion, les inserts creux et biseautés portés par le premier composant sont introduits partiellement dans les plots de connexion du second composant à hybrider. Cette étape est réalisée à l'aide d'une machine de placement standard, ne comportant pas d'appareillage à vide. Elle se déroule avantageusement à température ambiante ;
- l'insertion finale collective est réalisée sous vide dans un simple équipement de pressage, dépourvu de fonctions d'alignement.

Plus généralement et selon un autre aspect, l'invention concerne donc également un procédé d'hybridation entre un composant selon l'invention et un second composant doté de plots de connexion, qui comprend les étapes suivantes :

- alignement et insertion partielle des inserts dans les plots, avantageusement réalisés à température ambiante ;
- insertion finale, avantageusement réalisée sous vide.

Ce procédé en deux temps permet d'éviter la mise en oeuvre de machines et de technologie complexes et coûteuses.

Par ailleurs et comme déjà mentionné, les forces d'insertion mises en jeu sont notablement réduites en raison de l'aspect creux des inserts.

**BREVE DESCRIPTION DES FIGURES**

La manière dont l'invention peut être réalisée et les avantages qui en découlent ressortiront mieux de l'exemple de réalisation qui suit, donné à titre indicatif et non limitatif, à l'appui des figures annexées parmi lesquelles :

La figure 1 illustre les différents systèmes de connexion substrat/puce selon l'art antérieur.

La figure 2 schématise une vue en section d'un insert creux selon l'invention reposant, via un socle, sur le composant.

La figure 3 schématise l'hybridation de deux composants via l'insertion d'une protubérance creuse selon l'invention dans le caisson ductile correspondant et illustre l'augmentation de la surface de contact.

La figure 4 schématise les différentes étapes de fabrication d'un composant selon l'invention.

La figure 5 illustre les deux étapes supplémentaires mises en oeuvre lorsque la technique de remplissage - planarisation (mieux connue sous l'expression anglo-saxonne « *gap fill* ») est mise en oeuvre.

La figure 6 schématise une vue en section d'un insert creux et biseauté selon l'invention.

La figure 7 schématise un premier mode de fabrication de composants dotés d'inserts creux biseautés selon l'invention.

La figure 8 schématise un second mode de fabrication de composants dotés d'inserts creux biseautés selon l'invention.

La figure 9 détaille le procédé d'hybridation dans le cas d'un composant doté d'inserts creux et biseautés.

**MODES DE REALISATION DE L'INVENTION**

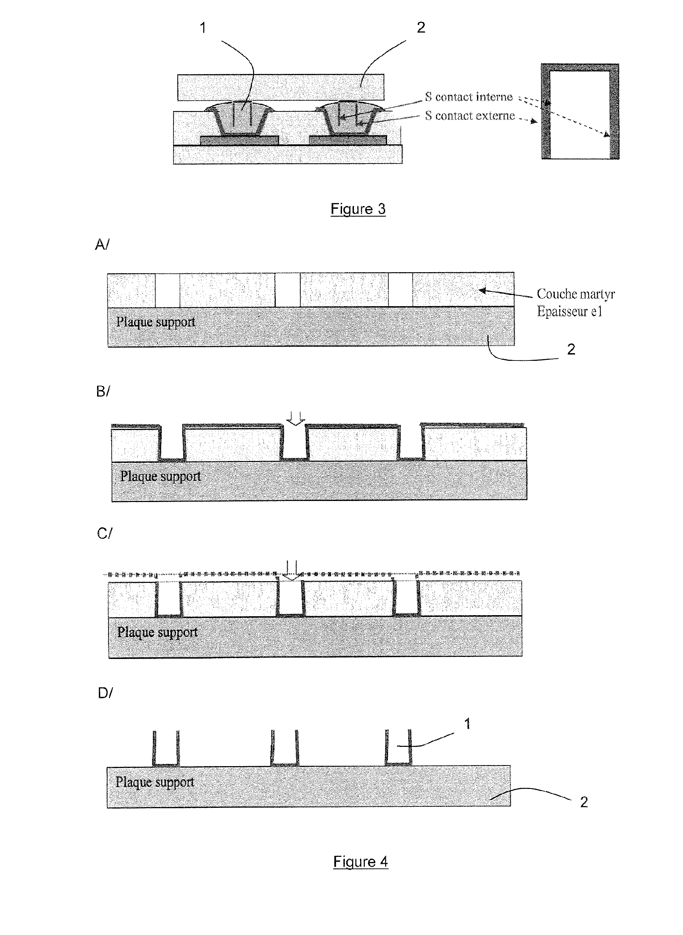

Un composant doté d'inserts présentant la configuration décrite dans le cadre de la présente invention peut être obtenu à l'aide du procédé illustré à la figure 4. Il s'agit typiquement d'un wafer CMOS (« *Complementary Metal-Oxide Semiconductor* »), issu d'une fonderie silicium.

La première étape (Fig. 4A) consiste à déposer une couche dite «martyr», d'épaisseur $e_1$ et réalisée à l'aide d'une résine. Cette couche est ensuite soumise à une photolithographie standard. Cette étape permet de créer des ouvertures du diamètre souhaité pour les tubes qui serviront d'inserts. Plus généralement, c'est lors de cette étape que la future forme de l'insert est fixée (hauteur, forme de l'ouverture...).

La seconde étape (Fig. 4B) correspond au dépôt du métal, éventuellement une multicouche de métal, correspondant au tube. C'est l'épaisseur de ce dépôt qui dictera l'épaisseur $e$ de l'insert creux. Le métal est avantageusement du cuivre, du titane, du tungstène, du WSi, du chrome ou un multicouche de ces matériaux.

Les diamètres d'ouverture sont maîtrisables à des valeurs inférieures à 1 micromètre et les hauteurs supérieures à 3 micromètres.

Les épaisseurs des métaux sont réglables et contrôlées jusqu'à des valeurs inférieures à 0,1 micromètres.

Il est possible de modifier, ou simplement compléter le dépôt métal habituel par une couche complémentaire d'un métal mouillable, avantageusement de l'or, du platine ou du cuivre. Ceci a pour avantage de faciliter la soudure ultérieure et la création des interfaces intermétalliques nécessaires lors de la soudure finale.

Dans un mode de réalisation privilégiée, l'insert creux prend une forme finale de « tube », correspondant à une ouverture circulaire. Toutefois, toute autre forme peut être réalisée par une conception adaptée du masque d'ouverture : triangle carré, polygone, ...

Avantageusement, la forme en creux peut présenter une section de taille variable, et par exemple en forme de cône ou de tronc de cône. Il suffit pour ce faire de jouer sur l'anisotropie de la gravure de la résine martyre.

Il est également possible de combiner des formes différentes sur une même plaque de fabrication et/ou sur une même puce à hybrider.

La troisième étape (Fig. 4C) consiste à retirer la couche métal située sur le plan supérieur de la résine martyre. Deux techniques de gravure de la face métal supérieure peuvent être utilisées :

*1/ Technique de « gravure damascène »*

Cette étape peut être réalisée de la même manière que les gravures damascène utilisées dans l'industrie du semiconducteur. On réalise un polissage mécanique ou mécanochimique de la face supérieure du substrat, la couche métal et une partie de la couche martyre de surface sont retirées, la partie du tube située dans l'ouverture n'étant gravée que sur une portion faible de sa hauteur.

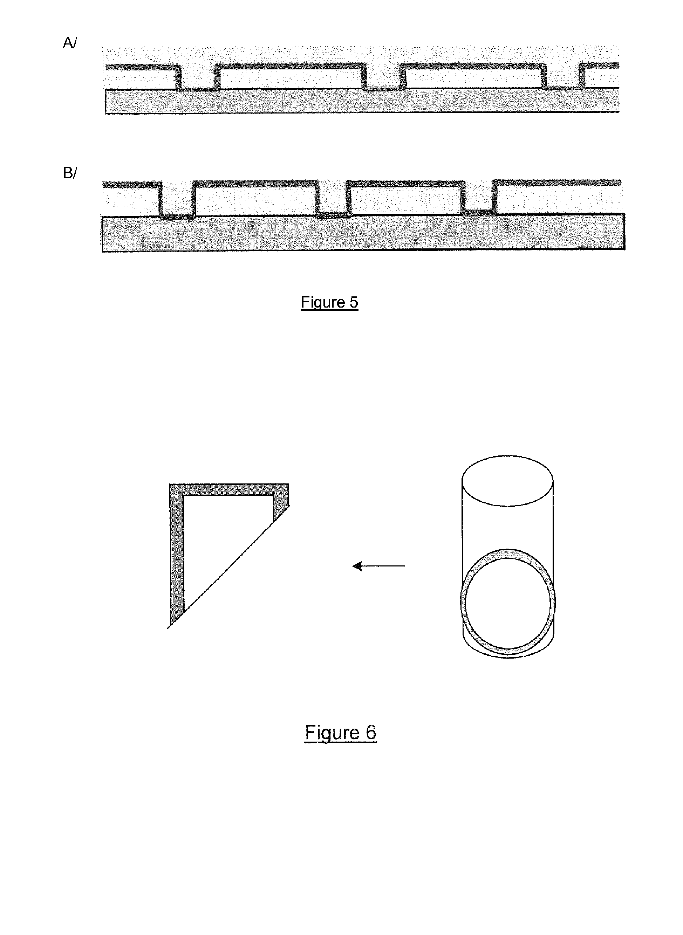

*2/ Technique « gap fill »* (Figure 5)

La plaque issue de l'étape précédente est couverte d'une résine fluide qui vient planariser l'ensemble de la surface et combler les ouvertures, comme illustré à la figure 5A.

La résine est ensuite gravée uniformément sur la plaque (pleine) jusqu'à atteindre la surface de métal supérieure (Fig. 5B). Une détection de fin d'attaque peut aisément être réalisée par analyse optique, analyse de gaz résiduel, ....

La figure 5B montre que les trous restent remplis de résine en final, du fait de leur forte profondeur et du bon contrôle de l'épaisseur de résine gravée pleine plaque.

Cette configuration est celle présente en sortie d'un masquage classique : on peut réaliser une gravure standard du métal «affleurant», le métal en fond d'ouverture étant toujours protégé par la résine de remplissage.

Un délaquage final de la résine encore présente au fond des ouvertures est ensuite effectué.

La dernière étape (Fig. 4D) correspond au retrait de la couche martyre. Il s'agit d'une étape parfaitement connue de délaquage.

A l'issue de ce procédé, il est possible de compléter la finition interne et externe des inserts par un dépôt de type «*electroless*», qui permet de garantir une non-oxydation postérieure de la surface du métal de l'insert. De l'or est préférentiellement utilisé dans cette étape. A noter que l'or dit «*electroless*» croît sur les zones métalliques exposées des inserts par le phénomène de dépôt « chimique » connu de l'homme du métier.

Ainsi et à titre d'exemple, sachant que la limite de résolution photolithographique d'une fabrique de semiconducteur est de 3 micromètres, pour une épaisseur de résine de 4 micromètres, il est possible de réaliser des tubes présentant les dimensions suivantes :

- hauteur (H) = 3 $\mu$m ;
- diamètre (D) = 3 $\mu$m ;
- pas = 5 $\mu$m ;
- épaisseur de la peau (e = épaisseur métal couche mince déposée) = 150nm (Ti+TiN+Au).

Un composant doté d'un tel insert est représenté à la figure 2.

Il est possible de calculer le gain en force d'insertion par rapport à un insert cylindrique de même diamètre :

$$F'/F = 4*e/D = 4*0,15/3 = 0,2.$$

La force d'insertion par insert est donc divisée par 5, en comparaison avec un insert classique de type «cylindre plein ». En d'autres termes, il est possible de multiplier par 5 le nombre de connexions, à force de thermocompression égale.

La figure 3 illustre, en outre, l'augmentation de surface de contact qui a lieu à la fois via les surfaces externes de l'insert, mais également via ses surfaces internes.

Selon un second mode de réalisation, l'insert creux est biseauté dans sa partie supérieure, comme illustré à la figure 6.

Deux procédés, dérivés de celui décrit ci-dessus, permettent d'obtenir un tel biseau.

*1/ Fabrication du biseau par gravure*

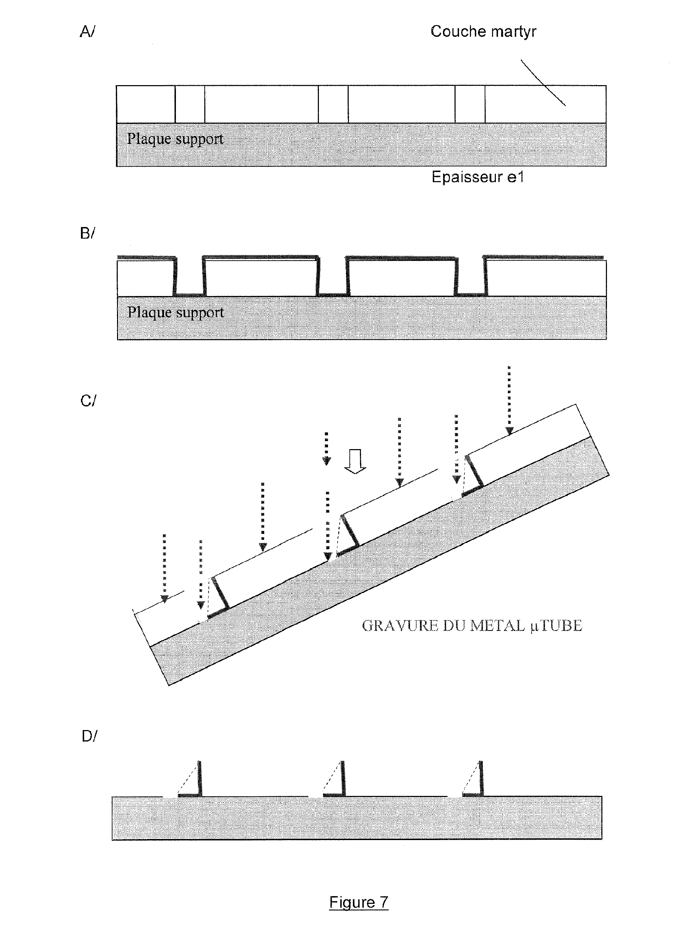

Les première et seconde étapes se déroulent comme décrit plus haut (Fig. 7A et 7B).

En revanche, le procédé est modifié lors l'étape de retrait de la couche métal, couche située sur le plan supérieur et sur le flan. Cette étape est réalisée par gravure « usinage ionique » (ou gravure RIE directive) ou toute autre gravure « directionnelle ».

En pratique, le support plaque est incliné d'un angle contrôlé par rapport à l'angle de gravure.

Ainsi et comme illustré à la Fig. 7C, le métal situé en surface et le métal situé dans le trou, mais non occulté par son flanc, sont gravés.

Le métal du trou situé « à l'ombre » du cône de gravure est conservé. Par exemple, en cas d'usinage ionique, il ne voit pas le faisceau ionique de gravure.

C'est l'angle plaque / direction de gravure qui définit le biseau.

Le retrait de la couche martyre se fait alors de manière classique pour donner la configuration illustrée à la Figure 7D.

*2/ Fabrication du biseau par dépôt*

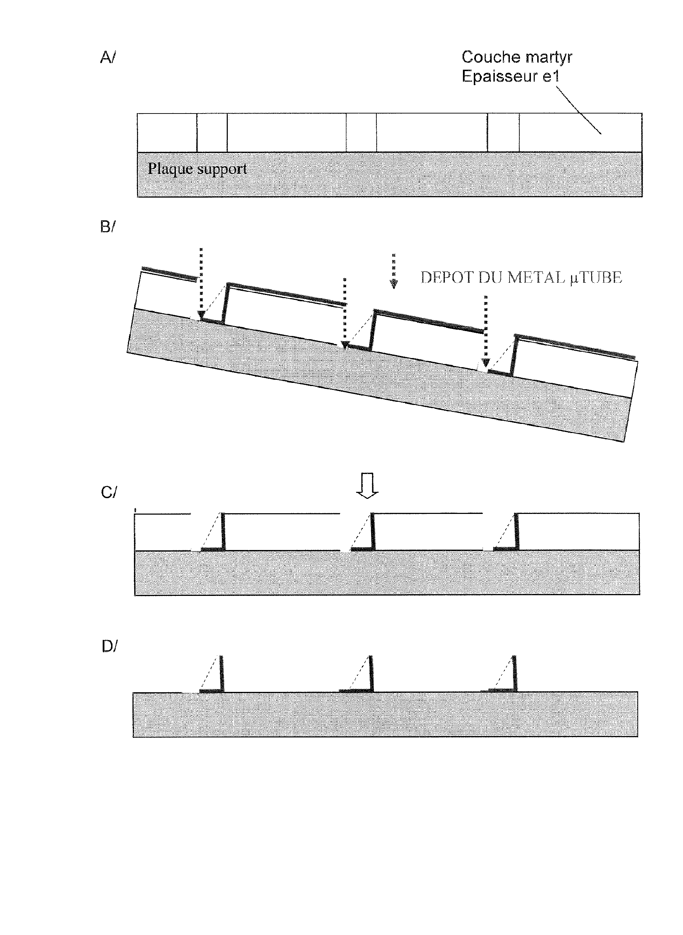

La première étape reste inchangée (Fig. 8A).

En revanche, lors du dépôt du métal (ou du multicouche métal), le support plaque est incliné d'un angle contrôlé par rapport à l'angle d'émission de la source métallique (Fig. 8B). Le dépôt est réalisé par pulvérisation ou évaporation. De fait, la partie du trou située « à l'ombre » du cône de dépôt ne voit pas de dépôt.

L'angle plaque / direction du dépôt définit le biseau.

Dans l'étape suivante (Fig. 8C), le retrait de la couche métal située sur le plan supérieur est réalisé par photolithographie, par procédé CMP damascène, ou procédé « gap fill » comme décrit ci-dessus.

Enfin, dans une ultime étape (Fig. 8D), on réalise le retrait de la couche martyre.

Cette configuration particulière des inserts permet de procéder à l'hybridation des deux composants à connecter électriquement et mécaniquement, en évitant toute formation de bulles d'air.

Un tel procédé se décompose en deux étapes:

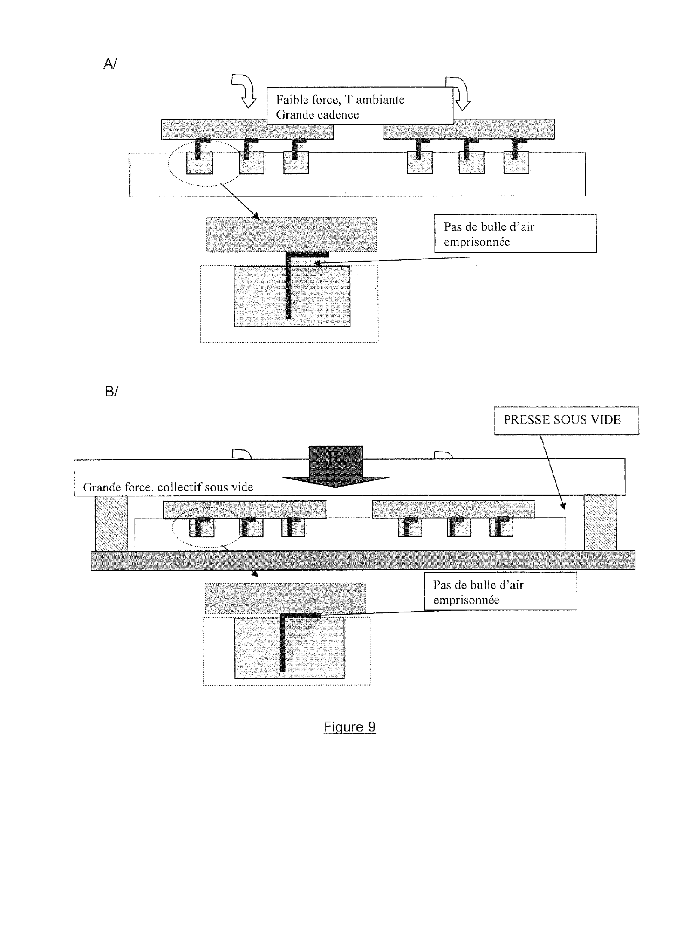

*1/ Prépositionnement précis, rapide, à faible force (Fig. 9A)*

Dans un premier temps, il s'agit de positionner toutes les puces à assembler, par préinsertion à faible force des tubes biseautés, dans les plots de soudure présents sur une face du second composant, à savoir le substrat.

Cette opération peut être réalisée à température ambiante et sous atmosphère standard.

Les puces à assembler sont rendues solidaires de la plaque mère (substrat) par assemblage C2W / « *chip to wafer* » (multihybridation de plusieurs puces sur une même plaque). La force d'insertion est calculée pour que les tubes ne s'insèrent que partiellement en vue de laisser un passage pour un dégazage ultérieur.

*2/ Insertion finale sous vide, à grande force (Fig. 9B)*

La plaque sur laquelle sont disposés des circuits préinsérés est ensuite sousmise à une grande force d'insertion, sous vide, afin de permettre l'introduction complète des inserts biseautés creux dans les plots de connexion correspondants.

Les avantages de la présente invention ressortent clairement de la présente demande.

Elle permet de réaliser des hybridations par insertion avec de très faibles forces d'insertion et une surface de contact significativement augmentée (doublée) par rapport à un insert classique.

Ceci permet de réaliser des inserts de très grand rapport de forme inscrits dans des pas d'interconnexion très fins, tout en utilisant des technologies parfaitement maîtrisées dans l'industrie du semi-conducteur.

Ainsi, la solution proposée permet de multiplier le nombre de points hybridés, à force d'insertion constante, tout en améliorant en parallèle la résistance d'accès pixel (d'un facteur 2 pour la même limite de résolution photolithographique). En outre, les inserts biseautés écartent tout risque de formation de bulles d'air au niveau de la connexion lors de l'hybridation.

Cette forme d'insert peut également être utilisée pour le composant à connecter. En effet, il existe trois types de connexion :

■ l'insert est inséré dans une zone enterrée de l'autre composant ;

■ l'insert est inséré dans une protubérance à la surface de l'autre composant ;

■ l'insert est inséré dans une protubérance creuse de forme similaire à la sienne. Il suffit alors que les diamètres respectifs soient adaptés : le diamètre intérieur de la protubérance est supérieur au diamètre extérieur de l'insert, ou réciproquement, mais les diamètres respectifs étant cependant suffisamment proches pour assurer le contact, notamment en suite de l'introduction en force de l'insert dans la protubérance.

Afin d'éviter le risque de destruction des inserts en raison de ce mode d'introduction, il est avantageux d'appliquer les principes d'assemblages mécaniques standards. De fait, on préférera des formes complémentaires de type cône/cône, cône/cône inversé, cône/tube. L'assemblage peut ainsi être réversible (connexion/déconnexion).

La présente invention trouve de nombreuses applications, notamment :

- pour les matrices de détection hétérogènes, de grande taille, à grand nombre de connexions par insertion (IRCMOS, CMT refroidis, détecteurs X, etc...) ;
- pour les matrices sensibles à la température hybridées à « froid » ;
- pour les matrices sensibles aux contraintes mécaniques.

**Revendications**

1. Composant de connexion (2) muni sur une surface de connexion d'inserts (1) conducteurs destinés à être insérés dans des plots conducteurs respectifs ménagés sur une face d'un autre composant de connexion pour une hybridation du type face contre face, chaque insert (1) comprenant :

   ■ une âme métallique creuse constituée d'un fond disposé sur la surface de connexion du composant et d'une paroi latérale faisant saillie dudit fond, définissant une surface interne de l'insert; et
   ■ une couche métallique mouillable recouvrant uniquement la surface interne de l'âme métallique.

2. Composant selon la revendication 1, dans lequel la couche métallique mouillable est de l'or, du platine ou du cuivre.

3. Composant selon la revendication 1 ou 2, dans lequel l'insert (1) est fermé à sa base à l'aide d'un socle reposant à la surface du composant (2), ledit socle présentant la même composition que le corps de l'insert.

4. Composant selon la revendication 1, 2 ou 3, dans lequel que l'insert (1) présente une section annulaire, notamment ronde ou ovale, ou parallélépipédique, en particulier carré ou rectangle.

5. Composant selon l'une quelconque des revendications précédentes, dans lequel l'insert (1) présente un diamètre D et une épaisseur e, e étant très inférieure à D.

6. Composant selon l'une quelconque des revendications précédentes, dans lequel l'âme métallique creuse est constituée d'un ou de plusieurs matériaux sont choisis dans le groupe constitué de : Cu, Ti, W, WSi, Cr, Ni, Pd, Pt, WN, TiN.

7. Procédé de réalisation d'un composant de connexion conforme à l'une quelconque des revendications précédentes, comprenant les étapes consécutives de :

   ■ dépôt d'une couche de résine sur la surface de connexion du composant (2) ;
   ■ réalisation, dans la couche de résine, d'ouvertures adaptées à la forme des inserts (1) ;
   ■ dépôt du ou des matériaux constitutifs de l'âme des inserts (1) sur la surface de la couche de résine;
   ■ dépôt du matériau mouillable sur la surface de la couche de résine ;
   ■ élimination du ou des matériaux sur le plan supérieur de la couche de résine ;
   ■ retrait de la couche de résine.

8. Procédé selon la revendication 7, dans lequel les ouvertures dans la couche de résine sont réalisées par photolithographie.

9. Procédé de réalisation selon la revendication 7 ou 8, dans lequel le dépôt du ou des matériaux constitutifs des inserts (1) suivant la surface de la couche est réalisé à l'aide de techniques de dépôt de couche mince.

10. Procédé de réalisation selon l'une des revendications 7 à 9, dans lequel l'élimination du ou des matériaux sur le plan supérieur de la couche est réalisée par gravure.

11. Procédé de réalisation selon l'une des revendications 7 à 10, dans lequel le retrait de la couche est réalisé par délaquage.

12. Procédé de réalisation selon l'une des revendications 7 à 11, dans lequel le composant (2) est incliné selon une orientation définie, lors du dépôt du ou des matériaux constitutifs des inserts (1) ou lors de son élimination, de sorte à réaliser des inserts présentant une extrémité libre biseautée.

A

P

Bump

B

P

Insert

Caisson soudure

B

Metal

**ART ANTERIEUR**

Figure 1

$D$

$e = (D-D0)/2$

$D0$

$e$

$H$

1

2

Pas

Figure 2

1   2

S contact interne
S contact externe

Figure 3

A/

Couche martyr
Epaisseur e1

Plaque support

2

B/

Plaque support

C/

Plaque support

D/

1

Plaque support

2

Figure 4

A/

B/

Figure 5

Figure 6

A/

Couche martyr

Plaque support

Epaisseur e1

B/

Plaque support

C/

GRAVURE DU METAL µTUBE

D/

Figure 7

A/

Couche martyr
Epaisseur e1

Plaque support

B/

DEPOT DU METAL µTUBE

C/

D/

A/

Faible force, T ambiante
Grande cadence

Pas de bulle d'air
emprisonnée

B/

PRESSE SOUS VIDE

F

Grande force, collectif sous vide

Pas de bulle d'air
emprisonnée

Figure 9

Europäisches
Patentamt

European
Patent Office

Office européen
des brevets

**RAPPORT DE RECHERCHE EUROPEENNE**

Numéro de la demande

EP 13 16 3706

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X<br>A | US 6 388 322 B1 (GOOSSEN KEITH W [US] ET AL) 14 mai 2002 (2002-05-14)<br>* colonne 6, ligne 20 - colonne 8, ligne 10; figures 4-8 *<br>* colonne 9, ligne 36 - colonne 11, ligne 18; figures 11-15 *<br>----- | 1-11<br>12 | INV.<br>H01L21/60<br>H01L23/485 |
| A | US 2004/197979 A1 (JEONG SE-YOUNG [KR] ET AL) 7 octobre 2004 (2004-10-07)<br>* alinéas [0001] - [0010], [0036] *<br>* alinéas [0050] - [0055]; figures 7A,7B,8A-8E *<br>* alinéas [0056] - [0060]; figures 9A,9B *<br>* alinéas [0061] - [0067]; figures 10A-10j,11A-11E *<br>* alinéa [0068]; figures 12A,12B *<br>----- | 1-12 | |
| A,D | WO 2006/054005 A1 (COMMISSARIAT ENERGIE ATOMIQUE [FR]; DAVOINE CECILE [FR]; FENDLER MANUE) 26 mai 2006 (2006-05-26)<br>* page 6, ligne 7 - page 7, ligne 27; figures 2A,2B *<br>----- | 1-12 | |

| | DOMAINES TECHNIQUES RECHERCHES (IPC) |
|---|---|
| | H01L |

Le présent rapport a été établi pour toutes les revendications

| Lieu de la recherche | Date d'achèvement de la recherche | Examinateur |
|---|---|---|
| Munich | 31 mai 2013 | Corchia, Alessandra |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 13 16 3706

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

31-05-2013

| Document brevet cité au rapport de recherche | | Date de publication | Membre(s) de la famille de brevet(s) | | Date de publication |
|---|---|---|---|---|---|
| US 6388322 | B1 | 14-05-2002 | US | 6388322 B1 | 14-05-2002 |
| | | | US | 6458411 B1 | 01-10-2002 |
| US 2004197979 | A1 | 07-10-2004 | CN | 1601712 A | 30-03-2005 |
| | | | DE | 102004041514 A1 | 04-05-2005 |
| | | | JP | 2005101614 A | 14-04-2005 |
| | | | US | 2004197979 A1 | 07-10-2004 |
| | | | US | 2006113681 A1 | 01-06-2006 |
| WO 2006054005 | A1 | 26-05-2006 | EP | 1797748 A1 | 20-06-2007 |
| | | | FR | 2876243 A1 | 07-04-2006 |
| | | | JP | 2008516424 A | 15-05-2008 |
| | | | US | 2008190655 A1 | 14-08-2008 |
| | | | WO | 2006054005 A1 | 26-05-2006 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2006054005 A

- US 6179198 B